# EUROPÄISCHE PATENTSCHRIFT

(11) **EP 1 524 891 B1**
(45) Veröffentlichungstag und Bekanntmachung des Hinweises auf die Patenterteilung: **13.12.2006**
(21) Anmeldenummer: 03023525.3
(22) Anmeldetag: 15.10.2003
(51) Int. Cl.: H05K 7/14

(54) **Entriegelung von Elektronikmodulen bei dezentralen Peripheriebaugruppen**
Unlocking of electronic modules in decentralized peripheral units
Déverrouillage de modules électroniques dans des unités périphériques décentralisées

(43) Veröffentlichungstag der Anmeldung: 20.04.2005
(73) Patentinhaber: SIEMENS AKTIENGESELLSCHAFT, 80333 München (DE)
(72) Erfinder: Bergmann, Martin, 92253 Schnaittenbach (DE)

(56) Entgegenhaltungen:
- EP-A- 1 282 348
- US-A- 6 081 048
- US-A- 6 147 877
- US-B1- 6 172 875
- US-B1- 6 468 092

## Beschreibung

Die Erfindung betrifft ein System zur Befestigung und Entriegelung von Elektronikmodulen, insbesondere bei dezentralen Peripheriebaugruppen.

Elektrische bzw. elektronische Baugruppen, insbesondere solche in der dezentralen Peripherie, sind in der Regel auf einer Trägerplatte bzw. auf einem Terminalmodul fixiert und an ein Bussystem zur Kommunikation angeschlossen. Die Baugruppen weisen zur Verbindung mit Feldgeräten, beispielsweise Sensoren und Aktoren, die Rahmen eines Automatisierungssystems für die Prozesssteuerung verantwortlich sind, in der Regel Steckverbindungen für die Signalein- und -ausgänge auf. Im Rahmen eines Automatisierungssystems müssen die elektrischen bzw. elektronischen Baugruppen mitunter ausgewechselt werden. Hierzu ist neben dem Lösen der Steckverbindungen für die Endgeräte ein Auswechseln unter Umständen vorhandener Kennzeichnungsschilder am Gehäuse der Baugruppen vonnöten. Bei einem Austausch einer Baugruppe besteht somit die Gefahr, dass sowohl die Kennzeichnungsschilder als auch die Steckverbinder nach Einbau der neuen Baugruppe verwechselt bzw. an falsche Positionen gesetzt werden. Es hat sich gezeigt, dass die Fehlersuche in solch einem Fall sich im Allgemeinen als sehr schwierig erweist.

Aus der US 6 468 092 ist ein System bekannt, bei dem eine Baugruppe aus einem elektronischen Teil und einem Adapter besteht, wobei der Adapter über Ein- und Ausgänge für die Steckverbindungen zu den Feldgeräten verfügt und den elektronischen Teil nach außen hin abschirmt. Der elektronische Teil der Baugruppe kann ausgewechselt werden, ohne dass die Steckverbindungen vom Adapter gelöst werden müssen.

Aus der US 6 147 877 ist eine Vorrichtung bekannt, welche den Austausch einer Baugruppe ohne Lösen der elektrischen Anschlüsse erlaubt.

Die Aufgabe der vorliegenden Erfindung besteht darin, ein verbessertes System zum Auswechseln einer elektrischen bzw. elektronischen Baugruppe anzugeben.

Die Aufgabe wird gelöst durch eine elektrische Baugruppe, insbesondere eine Baugruppe einer dezentralen Peripherie eines Automatisierungssystems, zur Befestigung auf einer Trägerplatte, mit einem Elektronikmodul und mit einem mit dem Elektronikmodul koppelbaren Steckermodul zum Herstellen mindestens einer Steckverbindung, dadurch gekennzeichnet, dass das Steckermodul an der Trägerplatte verbleibend vom Elektronikmodul abschwenkbar ist, wodurch das Elektronikmodul auswechselbar ist.

Der Erfindung liegt die Erkenntnis zugrunde, dass beim Auswechseln von Elektronikmodulen, insbesondere im Rahmen der dezentralen Peripherie eines Automatisierungssystems, Verwechslungen bezüglich der Steckerverbindungen zu den Feldgeräten sowie auch der Kennzeichnungsschilder auftreten können. Das Beheben dieser Fehler kostet in der Regel Zeit und ist relativ aufwändig und schwierig. Im Rahmen der vorliegenden Erfindung kann eine Baugruppe bzw. das Elektronikmodul einer Baugruppe auf einfache Weise ausgewechselt werden. Dadurch, dass ein Steckermodul mit dem Elektronikmodul gekoppelt ist und das Steckermodul beim Wechseln der Baugruppe bzw. des Elektronikmoduls jedoch abschwenkbar ist, können die beiden Teile, Steckermodul und Elektronikmodul, unabhängig voneinander ausgewechselt werden. Wird das Steckermodul vom Elektronikmodul abgeschwenkt, so liegt das Elektronikmodul darunter frei und kann vom Terminalmodul abgenommen werden. Hierbei verbleibt das schwenkbare Steckermodul am Terminalmodul. Die Steckverbindungen zu den Feldgeräten sowie gegebenenfalls vorhandene Kennzeichnungsschilder müssen nicht ausgewechselt werden. Ein Fehler bei falscher Zuordnung der Steckverbindungen nach Austausch des Elektronikmoduls unterbleibt somit. Ein einfaches, fehlerfreies Austauschen der Elektronikmodule bzw. Baugruppen im Rahmen der dezentralen Peripherie wird hierdurch möglich.

Eine weitere vorteilhafte Ausbildung der Erfindung ist dadurch gekennzeichnet, dass das Elektronikmodul ein Rastelement zum Einrasten an einem an der Trägerplatte angeordneten Busmodul aufweist. Beim Abschwenken des Steckermoduls verbleibt somit das Elektronikmodul erst einmal am Terminalmodul bzw. an der Trägerplatte. Das Elektronikmodul kann begutachtet bzw. sogar manipuliert werden, ohne dass eine direkte Demontage des Elektronikmoduls erfolgt. Hierbei verfügt das Elektronikmodul selbst über ein Rastelement, mit dem es an dem Busmodul, welches an der Trägerplatte aufsitzt, festgerastet ist.

Eine weitere vorteilhafte Ausbildung der Erfindung ist dadurch gekennzeichnet, dass das Steckermodul eine Kulisse zur Entriegelung des Rastelements des Elektronikmoduls aufweist, wobei die Entriegelung durch die Schwenkbewegung des Steckermoduls erfolgt. Vorteilhaft hierbei ist vor allem, dass für eine Entriegelung des Rastelements des Elektronikmoduls keine weitere Bedienung durch den Monteur direkt am Elektronikmodul nötig ist. Ein Hantieren mit Werkzeugen zur Demontage des Elektronikmoduls kann somit unterbleiben. Hierdurch wird eine besonders schonende Möglichkeit gegeben, das Elektronikmodul vom Busmodul zu entrasten. Die Bedienung ist zudem besonders einfach, da nach einmal erfolgtem Lösen des Steckermoduls das Elektronikmodul lediglich durch die Fortführung der ohnehin bereits ausgeführten Schwenkbewegung, ohne weitere händische Tätigkeiten entriegelt werden kann. Nach einmal begonnener Schwenkbewegung, kann die Entriegelung somit einhändisch erfolgen.

Eine weitere vorteilhafte Ausbildung der Erfindung ist dadurch gekennzeichnet, dass das Steckermodul ein Schiebeelement zum Lösen des entriegelten Elektronikmoduls vom Busmodul aufweist. Nachdem das Elektronikmodul somit einmal durch Fortführung der Schwenkbewegung entriegelt ist, führt eine weitere Fortführung der einmal begonnenen Schwenkbewegung dazu, dass das Elektronikmodul vollständig vom Busmodul und damit vom Terminalmodul bzw. der Trägerplatte gelöst wird. Insgesamt wird durch immer weiteres Ausführen der Schwenkbewegung des Steckermoduls eine besonders einfache und schonende Entrastung und Loslösung des Elektronikmoduls bzw. des elektrischen Teils einer Baugruppe ermöglicht.

Eine weitere vorteilhafte Ausbildung der Erfindung ist dadurch gekennzeichnet, dass das Steckermodul über eine Haltevorrichtung zur Aufnahme des gelösten Elektronikmoduls verfügt. Nachdem das Elektronikmodul somit mithilfe der am Steckermodul befindlichen Kulisse sowie des Schiebers einmal entriegelt und anschließend gelöst wurde, wird es von dem das Elektronikmodul quasi umgebende und abdeckende und somit schützende Steckermodul aufgefangen. Aus dieser Haltevorrichtung, in der es nach dem Entriegelungsvorgang dann liegt, kann das Elektronikmodul dann entnommen werden. Anschließend kann ein neues Elektronikmodul in diese Haltevorrichtung gelegt werden und durch Zuklappen des Steckermoduls wird das Elektronikmodul in entsprechender Position am Busmodul und damit an der Trägerplatte wieder befestigt.

Vorteilhaft ist im Rahmen des gesamten Auswechselns einer derartigen elektrischen Baugruppen vor allem, dass neben der einfachen Bedienbarkeit während des gesamten Vorgangs die Steckverbindungen am Steckermodul zu den entsprechenden Feldgeräten des Automatisierungssystems nicht gelöst werden müssen. Ebenso können gegebenenfalls vorhandene Kennzeichnungsschilder an dem Steckermodul verbleiben.

Eine weitere vorteilhafte Ausbildung der Erfindung ist dadurch gekennzeichnet, dass eine Trägerplatte zur Aufnahme einer elektrischen Baugruppe, insbesondere einer Baugruppe der dezentralen Peripherie, vorgesehen ist, mit einer Schiene zur Aufnahme mindestens eines Busmoduls und mit einer Lagervorrichtung zum Einhängen mindestens eines Steckermoduls. Das von der eigentlichen Baugruppe unabhängig existierende Busmodul verbleibt somit am Terminalmodul bzw. an der Trägerplatte. Die Trägerplatte verfügt zudem über eine Lagervorrichtung, in die das Steckermodul einer elektrischen Baugruppe eingehängt wird. Wird das Steckermodul einer elektrischen Baugruppe somit vom Elektronikmodul abgeschwenkt, hängt es an einem Ende nach wie vor in der Lagervorrichtung der Trägerplatte. Hierdurch ist das Steckermodul zwar beweglich schwenkbar, kann aber zum Wechseln eines Elektronikmoduls der Baugruppe an seiner Position im Rahmen des Terminalmoduls bzw. der Trägerplatte verbleiben. Muss das Steckermodul jedoch ganz ausgetauscht werden, so kann es auf einfache Weise ganz aus dem Lager ausgeschwenkt werden, ohne dass weitere Manipulation durch den Monteur nötig wäre. Insbesondere sind keine weiteren Schraubverbindungen zum Lösen des Steckermoduls zu betätigen.

Im Folgenden wird die Erfindung anhand der Figur näher beschrieben und erläutert.

Die Figur stellt eine Trägerplatte 3 dar, auf der eine oder mehrere Baugruppe bzw. Baugruppen, jeweils bestehend aus einem Elektronikmodul 1 und einem Steckermodul 2, befestigt wird bzw. werden. Die Trägerplatte 3 verfügt über eine Schiene 12, zur Befestigung eines Busmoduls 4. Das Elektronikmodul 1 ist am Busmodul 4 oder direkt an der Trägerplatte 3 mit einem Rastelement 5 eingerastet. Das Steckermodul 2 verfügt über ein Schiebeelement 7 mit einer am Ende des Schiebeelements 7 angeordneten Kulisse 6. Das Steckermodul 2 ist über ein Lager 10 in einer Lagervorrichtung 9 der Trägerplatte 3 eingehängt. Das Steckermodul 2 verfügt über eine Haltevorrichtung 8 für das Elektronikmodul 1. Des Weiteren verfügt das Steckermodul 2 über mehrere Ein- und Ausgänge bzw. Verbindungsmöglichkeiten 11 für Feldgeräte. Das Steckermodul 2 ist über eine Schnittstelle 21 mit dem Elektronikmodul 1 verbunden.

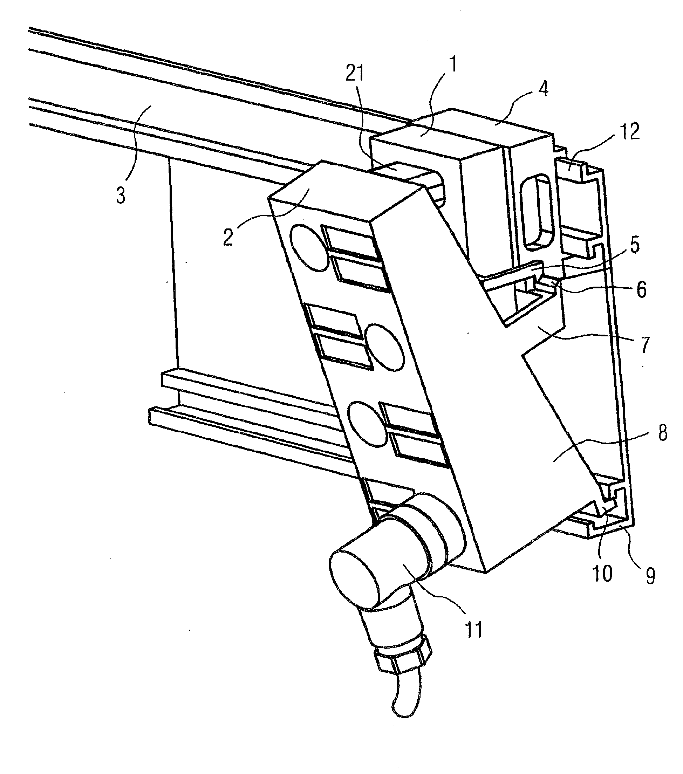

Bei der beispielhaften Ausführungsform der Erfindung in Figur 1 ist das Elektronikmodul 1 mittels eines Rastelements 5 bzw. einer Verrastung an dem Busmodul 4, welches wiederum an der Trägerplatte 3 bzw. am Terminalmodul befestigt ist, gehalten. Das Elektronikmodul 1 kann jedoch auch direkt an der Trägerplatte 3 mittels des Rastelements 5 befestigt sein. In diesem Fall wäre auch ein einfaches Wechseln des Busmoduls 4 möglich.

Das Steckermodul 2 kann zum Austausch des Elektronikmoduls 1 vom Elektronikmodul 1 gelöst werden. Hierbei wird die elektrische Verbindung über die Schnittstelle 21, die das Elektronikmodul 1 mit dem Steckermodul 2 verbindet, unterbrochen. Das Elektronikmodul 1 liegt nun frei, ist jedoch durch das Rastelement 5 noch in Verbindung mit dem Busmodul 4 oder ggf. mit der Trägerplatte 3. Wird das Steckermodul 2 in der einmal eingeschlagenen Richtung der Schwenkbewegung weiter bewegt, so löst die am Steckermodul 2 angeformte Kulisse 6 die Verrastung bzw. das Rastelement 5, welches das Elektronikmodul 1 mit dem Busmodul 4 verbindet. Anschließend, nach erfolgter Entrastung, wird das Elektronikmodul 1 vom Busmodul 4 gelöst. Dies erfolgt durch das ebenfalls am Steckermodul 2 angeformte Schiebeelement 7. Das Schiebeelement 7 zieht das Elektronikmodul 1 quasi vom Busmodul 4 herunter. Das Elektronikmodul 1 liegt anschließend frei in der Haltevorrichtung 8 des Steckermoduls 2. Das Elektronikmodul 1 kann jetzt aus der Haltevorrichtung 8 entnommen werden und ausgetauscht werden. Hierbei muss keine weitere Verbindung gelöst werden. Insbesondere die Steckverbinder 11 zu den Feldgeräten können am Steckermodul 2 verbleiben. Das gesamte Steckermodul 2 hängt mithilfe des Lagers 10 in der Lagervorrichtung 9 des Terminalmoduls bzw. der Trägerplatte 3. Das Einsetzen des Elektronikmoduls 1 erfolgt in umgekehrter Reihenfolge. Das Elektronikmodul 1 wird hierbei in die Haltevorrichtung 8 eingebracht und durch Schließen des Steckermoduls 2 wird das Elektronikmodul 1 über die Schnittstelle 21 kontaktiert und an der Trägerplatte 3 gehalten.

Die Erfindung betrifft zusammenfassend eine elektrische Baugruppe, eine Trägerplatte und ein System zum einfachen Austausch von Elektronikmodulen der dezentralen Peripherie eines Automatisierungssystems. Die elektrische Baugruppe besteht aus einem Elektronikmodul 1 und einem Steckermodul 2, welche beweglich gekoppelt sind. Zum Wechseln der Baugruppe kann das Steckermodul 2 vom Elektronikmodul 1 abgeschwenkt werden. Durch die Schwenkbewegung wird das Elektronikmodul 1 entriegelt und gelöst und liegt anschließend frei in einer Auffangvorrichtung 8 des Steckermoduls 2 und kann gewechselt werden. Das Steckermodul 2 selbst verbleibt an der Trägerplatte 3.

## Patentansprüche

1. System zur Befestigung und/oder zum Austausch einer elektrischen Baugruppe, insbesondere einer Baugruppe der dezentralen Peripherie eines Automatisierungssystems, bestehend aus
- einer elektronischen Baugruppe bestehend aus einem Elektronikmodul (1) und einem mit dem Elektronikmodul (1) koppelbaren Steckermodul (2) zum Herstellen mindestens einer Steckverbindung,
- einer Trägerplatte (3) zur Aufnahme mindestens einer aus mit dem Elektronikmodul (1) gekoppeltem Steckermodul (2) bestehenden elektrischen Baugruppe, wobei die Trägerplatte (3) eine Lagervorrichtung (9) zum Einhängen mindestens eines Steckermoduls (2) aufweist, wobei das Steckermodul (2) derart ausgestaltet ist, dass es an der Trägerplatte (3) verbleibend vom Elektronikmodul (1) abschwenkbar ist, wodurch das Elektronikmodul (1) auswechselbar ist.

2. System nach Anspruch 1,
**dadurch gekennzeichnet,**
**dass** das Elektronikmodul (1) ein Rastelement (5) zum Einrasten an der Trägerplatte und/oder an einem an der Trägerplatte (3) angeordneten Busmodul (4) aufweist.

3. System nach Anspruch 1 oder 2,
**dadurch gekennzeichnet,**
**dass** das Steckermodul (2) eine Kulisse (6) zur Entriegelung des Rastelements (5) aufweist, wobei die Entriegelung durch die Schwenkbewegung des Steckermoduls (2) erfolgt.

4. System nach einem der Ansprüche 1 bis 3,
**dadurch gekennzeichnet,**
**dass** das Steckermodul (2) ein Schiebeelement (7) zum Lösen des entriegelten Elektronikmoduls (1) von der Trägerplatte und/oder von dem an der Trägerplatte (3) angeordneten Busmodul (4) aufweist.

5. System nach Anspruch 4,
**dadurch gekennzeichnet,**
**dass** das Steckermodul (2) über eine Haltevorrichtung (8) zur Aufnahme des gelösten Elektronikmoduls (1) verfügt.

6. System nach einem der Ansprüche 1 bis 5,
**dadurch gekennzeichnet,**
**dass** das Steckermodul (2) ein Lager (10) zum Einhängen des Steckermoduls (2) in eine Lagervorrichtung (9) der Trägerplatte (3) aufweist.

7. System nach einem der Ansprüche 1 bis 6,
**dadurch gekennzeichnet,**
**dass** die Trägerplatte (3) eine Schiene (12) zur Aufnahme mindestens eines Busmoduls (4) aufweist.

## Claims

1. System for fastening and/or replacing an electrical unit, in particular a unit of the distributed input/output device of an automation system, comprising
- an electronic unit comprising an electronic module (1) and a connector module (2), which can be connected to the electronic module (1), for making at least one connection,
- a base plate (3) for holding at least one electrical unit comprising connector module (2) connected to the electronic module (1), the base plate (3) having a pivot device (9) for hinging at least one connector module (2), the connector module (2) being designed so that it can be swung away from the electronic module (1) while remaining on the base plate (3), thereby enabling the electronic module (1) to be replaced.

2. System according to Claim 1,
**characterised in that**
the electronic module (1) comprises a catch element (5) for engaging on the base plate and/or on a bus module (4) arranged on the base plate (3).

3. System according to Claim 1 or 2,
**characterised in that**
the connector module (2) has a slide block (6) for disengaging the catch element (5), it being disengaged by the swinging action of the connector module (2).

4. System according to one of the Claims 1 to 3,
**characterised in that**
the connector module (2) has a sliding element (7) for releasing the detached electronic module (1) from the base plate and/or from the bus module (4) arranged on the base plate (3).

5. System according to Claim 4,
**characterised in that**
the connector module (2) has a holding device (8) for receiving the released electronic module (1).

6. System according to one of the Claims 1 to 5,
**characterised in that**
the connector module (2) has a pivot (10) for hinging the connector module (2) in a pivot device (9) of the base plate (3).

7. System according to one of the Claims 1 to 6,
**characterised in that**
the base plate (3) has a rail (12) for holding at least one bus module (4).

## Revendications

1. Système pour fixer et / ou échanger un bloc électrique, en particulier un bloc de la périphérie décentralisée d'un système d'automatisation, se composant
- d'un bloc électronique, se composant d'un module électronique (1) et d'un module de connexion (2), pouvant être couplé au module électronique (1), pour établir au moins un raccord enfichable,
- d'une plaque support (3), pour recevoir au moins un bloc électrique, se composant du module de connexion (2), couplé au module électronique (1), la plaque support (3) présentant un mécanisme de logement (9), pour suspendre au moins un module de connexion (2), le module de connexion (2) étant configuré de telle sorte qu'il peut être mis en pivotement par le module électronique (1), en demeurant sur la plaque support (3), moyen par lequel le module électronique (1) peut être échangé.

2. Système selon la revendication 1, **caractérisé en ce que** le module électronique (1) présente un élément à encliqueter (5), pour l'encliqueter sur la plaque support et / ou sur un module de bus (4), disposé sur la plaque support (3).

3. Système selon la revendication 1 ou 2, **caractérisé en ce que** le module de connexion (2) présente une coulisse (6), pour déverrouiller l'élément à encliqueter (5), le déverrouillage s'opérant par le biais du mouvement de pivotement du module de connexion (2).

4. Système selon l'une des revendications 1 à 3, **caractérisé en ce que** le module de connexion (2) présente un élément coulissant (7), pour détacher le module électronique (1) déverrouillé de la plaque support et / ou du module de bus (4), disposé sur la plaque support (3).

5. Système selon la revendication 4, **caractérisé en ce que** le module de connexion (2) dispose d'un mécanisme de retenue (8), pour recevoir le module électronique (1) détaché.

6. Système selon l'une des revendications 1 à 5, **caractérisé en ce que** le module de connexion (2) présente un support (10), pour suspendre le module de connexion (2) dans un mécanisme de logement (9) de la plaque support (3).

7. Système selon l'une des revendications 1 à 6, **caractérisé en ce que** la plaque support (3) présente un rail (12), pour recevoir au moins un module de bus (4).
